# EUROPÄISCHE PATENTSCHRIFT

(11) **EP 2 516 322 B1**
(45) Veröffentlichungstag und Bekanntmachung des Hinweises auf die Patenterteilung: **25.06.2014**
(21) Anmeldenummer: 10798264.7
(22) Anmeldetag: 17.12.2010
(51) Int. Cl.: B81C 1/00

(54) **VERFAHREN ZUR HERSTELLUNG VON KONUSFÖRMIGEN NANOSTRUKTUREN AUF SUBSTRATOBERFLÄCHEN**
METHOD FOR MAKING CONICAL NANOSTRUCTURES ON SUBSTRATE SURFACES
METHODE DE FABRICATION DE NANOSTRUCTURES CONIQUES SUR DES SURFACES DE SUBSTRAT

(30) Priorität: 23.12.2009 DE 102009060223
(43) Veröffentlichungstag der Anmeldung: 31.10.2012
(73) Patentinhaber: Max-Planck-Gesellschaft zur Förderung der Wissenschaften e.V., 80539 München (DE)
(72) Erfinder: MORHARD, Christoph, 70565 Stuttgart (DE); PACHOLSKI, Claudia, 70565 Stuttgart (DE); SPATZ, Joachim, P., 70569 Stuttgart (DE)
(74) Vertreter: Katzameyer, Michael
(86) Internationale Anmeldenummer: PCT/EP2010/007750
(87) Internationale Veröffentlichungsnummer: WO 2011/076369

(56) Entgegenhaltungen:
- WO-A1-2008/148462
- US-A1- 2009 231 714
- M. HAUPT ET AL: "Polymer Masks on Semiconductors: A Novel Way to Nanostructures", PHYSICA STATUS SOLIDI (B), Bd. 224, Nr. 3, 1. April 2001 (2001-04-01) , Seiten 867-870, XP55003341, ISSN: 0370-1972, DOI: 10.1002/(SICI)1521-3951(200104)224:3<867:: AID-PSSB867>3.0.CO;2-Q

## Beschreibung

Eine teilsweise Reflexion von Licht ist stets zu beobachten wenn Licht auf eine Grenzfläche, z.B. Luft/Glas oder umgekehrt, trifft. Bei senkrechtem Einfall auf eine Glasscheibe werden an jeder der beiden Grenzflächen etwa 4 % des einfallenden Lichts reflektiert. Dieser Wert erhöht sich für den Lichteinfall in einem spitzen oder stumpfen Winkel auf ca. 5 %. Diese Teilreflexion stellt für viele Anwendungen, beispielweise in optischen Elementen wie Linsen etc., bei denen eine möglichst hohe Transmission erwünscht ist, ein beträchtliches Problem dar.

Reflexionsmindernde Beschichtungen, die aus Dünnfilmen bestehen, sind im Handel erhältlich. Solche Beschichtungen sind jedoch kostspielig, ihre mechanische Stabilität ist häufig unbefriedigend und ihre Toleranz bezüglich des Einfallswinkels ist niedrig. In jüngerer Zeit wurden zur Lösung dieser Probleme Mikro- und Nanostrukturen auf den Oberflächen optischer Elemente aufgebracht, welche den Strukturen von Mottenaugen ähneln und daher auch anschaulich als Mottenaugen-Strukturen bezeichnet werden (Kanamori et al. (1999) OPTICS LETTERS 24(20), 1422-1424; Toyota et al. (2001), Jpn. J. Appl. Phys. 40 (7B), 747-749). Die meisten dieser Ansätze beruhen auf langsamen und kostspieligen Applikationsverfahren wie z.B. Elektronenstrahl-Lithographie.

Ein einfaches und kostengünstiges Verfahren, mit dem Mottenaugen-Strukturen durch Ätzen direkt auf Quarzglas erzeugt werden können, ist in der deutschen Offenlegungsschrift DE 10 2007 014 538 A1 und in der entsprechenden internationalen Veröffentlichung WO 2008/116616 A1 sowie in Lohmüller et al., NANO LETTERS 2008, Bd. 8, Nr. 5, 1429-1433, beschrieben. Das dort offenbarte Ätzverfahren ist jedoch insofern noch nicht optimal, als die damit erhältlichen Mottenaugen-Strukturen in der Regel auf einer Anordnung von säulenförmigen Strukturen basieren. Diese säulenförmigen Strukturen sind hinsichtlich ihrer Antireflexionswirkung den konusförmigen Mikrostrukturen auf einem natürlichen Möttenauge unterlegen. Mit dem genannten Verfahren ist es jedoch aus prinzipiellen Gründen schwer möglich, ideale konusförmige Strukturen herzustellen, da bei diesem Verfahren Goldpartikel als Ätzmaske verwendet werden und die Goldpartikel wesentlich langsamer als das Quarzglas der Substratoberfläche abgetragen werden. Ändert man die Parameter des beschriebenen Verfahren (z.B. zusätzlich Sauerstoff im Prozessgas, weniger Argonanteil), um eine stärker isotrope Abtragung zu erzielen, erhält man zwar teilweise konusförmige Strukturen; diese weisen jedoch immer ein relativ breites und deformiertes oberes Ende auf, welches die Antireflexionseigenschaften beeinträchtigt.

Ching-Mei Hsu et al. beschreiben in Applied Physics Letters 93, 133109 (2008) ein Verfahren zur Erzeugung von Säulen- und Konusstrukturen durch selektives Ätzen einer Silicium-Substratoberfläche, wobei vorher aufgebrachte SiO₂-Nanopartikel als Ätzmaske dienen. Dieses Verfahren ermöglicht jedoch nicht die Herstellung von Säulen- und Konusstrukturen, die selbst aus SiO₂ oder Quarzglas bestehen.

M. HAUPT et AL beschreibt in "Polymer Masks on Semiconductors: A Novel Way to Nanostructures", PHYSICA STATUS SOLIDI (B), Bd. 224, Nr. 3, 1. April 2001 (2001-04-01), Seiten 867-870, ein Verfahren zur Erzeugung von konusförmigen Nanostrukturen auf Substratoberflächen, umfassend das Bereitstellen einer mit Nanopartikeln bedeckten Substratoberfläche, und das Ätzen der mit Nanopartikeln bedeckten Substratoberfläche in einer Tiefe von mindestens 100 nm, wobei die Nanopartikel als Ätzmaske wirken.

Eine Aufgabe der vorliegenden Erfindung war somit die Bereitstellung von verschiedenen Substratoberflächen, einschließlich SiO₂-Oberflächen und Quarzglasoberflächen, insbesondere von optischen Elementen, welche eine reflexionsmindernde Anordnung von annähernd idealen konusförmigen Nanostrukturen aufweisen, auf möglichst einfache, materialsparende und kostengünstige Weise.

Diese Aufgabe wird erfindungsgemäß mit der Bereitstellung des Verfahrens nach Anspruch 1 gelöst. Spezielle oder bevorzugte Ausführungsformen und Aspekte der Erfindung sind Gegenstand der weiteren Ansprüche.

### Beschreibung der Erfindung

Das erfindungsgemäße Verfahren zur Erzeugung von konusförmigen Nanostrukturen auf einer Substratoberfläche nach Anspruch 1 umfasst mindestens die folgenden Schritte:
a) Bereitstellen einer mit Nanopartikeln bedeckten Substratoberfläche;
b) Ätzen der mit Nanopartikeln bedeckten Substratoberfläche in einer Tiefe von mindestens 100 nm, wobei die Nanopartikel als Ätzmaske wirken und die Ätzparameter so eingestellt werden, dass unterhalb der Nanopartikel Hyberboloid-Strukturen entstehen,
c) Brechen der Hyberboloid-Strukturen im Bereich des geringsten Durchmessers durch Ausübung mechanischer Kräfte, wobei die auf der Substratoberfläche verbleibenden Strukturen eine konusförmige Gestalt aufweisen, welche im Wesentlichen einer Hälfte eines einschaligen Hyberboloids entspricht.

Der Begriff "Hyperboloid", wie oben und im folgenden Text verwendet, bedeutet insbesondere ein "Rotationshyperboloid".

Vorzugsweise umfasst das erfindungsgemäße Verfahren im Ätzschritt b) mehrere Behandlungen mit demselben Ätzmittel und/oder mit verschiedenen Ätzmitteln. Besonders bevorzugt werden zwei verschiedene Ätzmittel abwechselnd eingesetzt. Das Ätzmittel kann grundsätzlich jedes im Stand der Technik bekante und für die jeweilige Substratoberfläche geeignete Ätzmittel sein. Vorzugsweise ist das Ätzmittel aus der Gruppe aus Chlorgasen, z.B. Cl₂, BCl₃ und anderen gasförmigen Chlorverbindungen, Fluorkohlenwasserstoffen, z.B. CHF₃, CH₂F₂, CH₃F, Fluorocarbonen, z.B. CF₄, C₂F₈, Sauerstoff, Argon, SF₆ und Mischungen davon ausgewählt. In einer besonders bevorzugten Ausführungsform wird SF₆ in mindestens einem Behandlungsschritt als Ätzmittel bzw. als Ätzmittelkomponente verwendet.

Die Dauer der gesamten Ätzbehandlung liegt typischerweise im Bereich von 1 Minute bis 30 Minuten, vorzugsweise 5 bis 15 Minuten.

Typischerweise wird beim Schritt b) ein Plasmaätzverfahren ("reactive ion etching") wie in DE 10 2007 014 538 A1 und Lohmüller et al. (NANO LETTERS 2008, Bd. 8, Nr. 5, 1429-1433) beschrieben eingesetzt und vorzugsweise wird ein Mischung von Argon mit mindestens einem anderen Prozessgas, z.B. CHF₃ oder SF₆, verwendet. Im Gegensatz zum Stand der Technik wird beim erfindungsgemäßen Verfahren allerdings nicht die direkte Erzeugung von säulenförmigen, pyramidalen oder konusförmigen Nanostrukturen angestrebt, sondern vielmehr die Bildung von Hyperboloid-Strukturen. Dies wird durch entsprechende Einstellung der Ätzparameter erzielt. Wesentlich ist eine große Ätztiefe von mindestens 100 nm, vorzugsweise mindestens 200 nm oder mindestens 300 nm, besonders bevorzugt mindestens 400 nm. Statt dem von Lohmüller et al. beschriebenen einstufigen Ätzprozess mit einem Argon/CF₄-Plasma werden erfindungsgemäß vorzugsweise mehrere und in der Regel kürzere Behandlungsschritte mit vorzugsweise mindestens zwei verschiedenen Ätzmitteln durchgeführt. Die einzelnen Behandlungsschritte haben dabei typischerweise eine Dauer von 10 Sekunden bis 2 Minuten, vorzugsweise 20 bis 60 Sekunden, und können 2-20 Mal, vorzugsweise 5-10 Mal, oder öfter wiederholt werden. Die Dauer der gesamten Ätzbehandlung liegt typischerweise im Bereich von 1 Minute bis 30 Minuten, vorzugsweise 5 bis 15 Minuten.

Besonders gute Ergebnisse werden bei Verwendung von SF₆ als Ätzmittel bzw. Ätzmittelkomponente in mindestens einem Behandlungsschritt erzielt. Insbesondere bei Si0₂ als Substratoberfläche werden damit wesentlich höhere Ätzraten als mit CF₄ realisiert.

Die erhaltenen Hyperboloid-Strukturen weisen im Bereich des geringsten Durchmessers typischerweise einen Durchmesser im Bereich von 5 nm bis 50 nm, vorzugsweise von 10 nm bis 30 nm auf. Dieser Bereich des geringsten Durchmessers bildet einen mechanischen Schwachpunkt der erhaltenen Strukturen und kann zu einem gezielten Bruch an dieser Stelle durch Ausübung mechanischer Kräfte genutzt werden. Die nach dem Brechen auf der Substratoberfläche verbleibenden Strukturen weisen eine konusförmige Gestalt auf, welche im Wesentlichen einer Hälfte eines einschaligen Hyberboloids, genauer eines einschaligen Rotationshyperboloids, entspricht und etwa die halbe Höhe der ursprünglichen Hyperboloid-Struktur aufweist. Die Höhe der konusförmigen Strukturen liegt typischerweise in einem Bereich von 50 nm bis 400 nm, vorzugsweise von 150 nm bis 300 nm. Die Seiten schließen vorzugsweise einen Winkel zwischen 3° und 35° mit der Normalen ein.

Die Ausübung mechanischer Kräfte in Schritt c) des erfindungsgemäßen Verfahrens kann beispielsweise durch eine Ultraschallbehandlung, Einwirkung von Vibrationen, pneumatischen Kräften oder durch Reibung geschehen. Eine Ultraschallbehandlung ist besonders bevorzugt, da auf die Weise die gewünschten konusförmigen Strukturen besonders schnell, leicht und effizient erzeugt werden können. Geeignete, nicht-beschränkende Bedingungen für eine solche Ultraschallbehandlung sind im folgenden Ausführungsbeispiel beschrieben. Variationen der Verfahrensbedingungen können jedoch in Abhängigkeit von dem eingesetzten speziellen Substrat zur Optimierung erforderlich sein und vom Fachmann unschwer durch Routineversuche ermittelt werden.

Die Substratoberfläche ist grundsätzlich nicht besonders beschränkt und kann jegliches Material umfassen, solange es dem Ätzschritt des erfindungsgemäßen Verfahren zugänglich ist und die vorhergehenden oder nachfolgenden Schritte nicht beeinträchtigt oder stört. Das Substrat kann beispielsweise aus Glas, Silicium, Halbleitern, Metallen, Polymeren etc. ausgewählt sein. Insbesondere für optische Anwendungen sind transparente Substrate bevorzugt. Besonders bevorzugt ist das Material der Substratoberfläche aus der Gruppe aus Quarzglas, SiO₂, Si, Al₂O₃, CaF₂, GaAs ausgewählt.

Für einige Anwendungen ist es bevorzugt, dass die als Ätzmaske verwendeten Nanopartikel eine vorgegebene zweidimensionale geometrische Anordnung auf der Substratoberfläche aufweisen. Eine solche Anordnung weist als ein Charakteristikum vorgegebene minimale oder mittlere Partikelabstände auf, wobei diese vorgegebenen Partikelabstände in allen Bereichen der Substratoberfläche gleich sein können oder verschiedene Bereiche unterschiedliche vorgegebene Partikelabstände aufweisen können. Eine derartige geometrische Anordnung kann grundsätzlich mit jedem geeigneten Verfahren des Standes der Technik, insbesondere mizellarer Nanolithographie wie im Folgenden näher erläutert, realisiert werden.

Erfindungsgemäß ist es bevorzugt, jedoch nicht unbedingt erforderlich, dass die Bedeckung der Substratoberfläche mit Nanopartikeln mit Hilfe einer Mizellen-Diblock-Copolymer-Nanolithographietechnik, wie z.B. in EP 1 027 157 B1 und DE 197 47 815 A1 beschrieben, geschieht. Bei der mizellaren Nanolithographie wird eine mizellare Lösung eines Blockcopolymers auf ein Substrat abgeschieden, z.B. durch Tauchbeschichtung, und bildet unter geeigneten Bedingungen auf der Oberfläche eine geordnete Filmstruktur von chemisch unterschiedlichen Polymerdomänen, die unter anderem von Typ, Molekulargewicht und Konzentration des Blockcopolymers abhängt. Die Mizellen in der Lösung lassen sich mit anorganischen Salzen beladen, die nach der Abscheidung mit dem Polymerfilm zu anorganischen Nanopartikeln oxidiert oder reduziert werden können. Eine Weiterentwicklung dieser Technik, in der Patentanmeldung DE 10 2007 017 032 A1 beschrieben, ermöglicht es, sowohl die laterale Separationslänge der genannten Polymerdomänen und damit auch der resultierenden Nanopartikel als auch die Größe dieser Nanopartikel durch verschiedene Maßnahmen so präzise flächig einzustellen, dass nanostrukturierte Oberflächen mit gewünschten Abstands- und/oder Größengradienten herstellbar sind. Typischerweise weisen mit einer solchen mizellaren Nanolithographietechnik hergestellte Nanopartikelanordnungen ein quasihexagonales Muster auf.

Grundsätzlich ist das Material der Nanopartikel nicht besonders beschränkt und kann jedes im Stand der Technik für solche Nanopartikel bekannte Material umfassen. Typischerweise handelt es sich dabei um ein Metall oder Metalloxid. Ein breites Spektrum geeigneter Materialien ist in DE 10 2007 014 538 A1 genannt. Vorzugsweise ist das Material des Metalls oder die Metallkomponente der Nanopartikel aus der Gruppe aus Au, Pt, Pd, Ag, In, Fe, Zr, Al, Co, Ni, Ga, Sn, Zn, Ti, Si und Ge, deren Mischungen und Kompositen ausgewählt. Spezielle Beispiele für ein bevorzugtes Metalloxid sind Titanoxid, Eisenoxid und Kobaltoxid. Bevorzugte Beispiele für ein Metall sind Gold, Palladium und Platin, und besonders bevorzugt ist Gold.

Der Begriff "Partikel" wie hier verwendet, umfasst auch einen "Clust-er", insbesondere wie in DE 10 2007 014 538 A1 und DE 197 47 815 A1 beschrieben und definiert, und beide Begriffe können hier austauschbar verwendet werden.

Im Ausführungsbeispiel werden geeignete Bedingungen zur Herstellung von konusförmigen Nanostrukturen auf einer Quarzglasoberfläche eingehender beschrieben. Für den Fachmann wird jedoch ersichtlich sein, dass Variationen dieser Bedingungen in Abhängigkeit von den verwendeten speziellen Materialien erforderlich sein können und unschwer durch Routineversuche zu ermitteln sind.

Die Produkte des erfindungsgemäßen Verfahrens bieten vielfältige Anwendungsmöglichkeiten auf den Gebieten der Halbleitertechnik, Optik, Sensortechnik und Photovoltaik.

Einige nicht-beschränkende Beispiele hierfür sind die Verwendung in optischen Vorrichtungen, insbesondere optischen Elementen wie Linsen, Gitter und andere refraktische oder defraktive Strukturen, Sensoren, insbesondere CCD-Sensoren, und Solarzellen.

Eine besonders bevorzugte Anwendung betrifft die Verwendung in optischen Elementen, insbesondere zur Reflexionsminderung.

### Kurzbeschreibung der Figuren

Fig. 1 zeigt schematisch die Hauptschritte des erfindungsgemäßen Verfahrens im Vergleich zum Stand der Technik.
Fig. 2 zeigt rasterelektronenmikroskopische Aufnahmen von geätzten säulenförmigen Nanostrukturen, die mit einem Verfahren des Standes der Technik hergestellt wurden.
Fig. 3 zeigt eine rasterelektronenmikroskopische Aufnahme von geätzten Hyperboloid-Strukturen, die mit dem erfindungsgemäßen Verfahren hergestellt wurden.
Fig. 4 zeigt rasterelektronenmikroskopische Aufnahmen von geätzten konusförmigen Nanostrukturen, die mit dem erfindungsgemäßen Verfahren hergestellt wurden.
Fig. 5 zeigt Transmissionsmessungen, welche die bessere Performance von Quarzglas-Oberflächen mit den erfindungsgemäß erhaltenen konusförmigen Strukturen im Vergleich zu massiven säulenförmigen Strukturen und unbeschichteten Oberflächen belegen.

Die folgenden Beispiele dienen zur näheren Erläuterung der vorliegenden Erfindung, ohne diese jedoch darauf zu beschränken.

### BEISPIEL 1

### Erzeugung von konusförmigen Nanostrukturen auf einem Substrat mit einer Anordnung von Gold-Nanopartikeln

### 1. Bereitstellung der Substratoberfläche

Zunächst wurde eine Substratoberfläche, z.B. Quarzglas, mittels mizellarer Nanolithographie mit Gold-Nanopartikeln in einer definierten Anordnung bedeckt. Bei diesem Schritt kann einem der in EP 1 027 157 B1, DE 197 47 815 A1 oder DE 10 2007 017 032 A1 beschriebenen Protokolle gefolgt werden. Das Verfahren beinhaltet die Abscheidung einer mizellaren Lösung eines Blockcopolymers (z.B. Polystyrol(n)-b-Poly(2-vinylpyridin(m)) in Toluol) auf das Substrat, z.B. durch Tauchbeschichtung, wodurch auf der Oberfläche eine geordnete Filmstruktur von Polymerdomänen gebildet wird. Die Mizellen in der Lösung sind mit einem Goldsalz, vorzugsweise HAuCl₄, beladen, welches nach der Abscheidung mit dem Polymerfilm zu den Gold-Nanopartikeln reduziert wird. Die Reduktion kann chemisch, z.B. mit Hydrazin, oder mittels energiereicher Strahlung wie Elektronenstrahlung oder Licht erfolgen. Verzugsweise wird nach oder gleichzeitig mit der Reduktion der Polymerfilm entfernt (z.B. durch Plasmaätzung mit Ar-, H- oder O-Ionen). Danach ist die Substratoberfläche mit einer Anordnung von Gold-Nanopartikeln bedeckt.

Anschließend erfolgte die Ätzung der mit Gold-Nanopartikeln bedeckten Substratoberfläche (Quarzglas) in einer Tiefe von mindestens 100 nm. Dazu wurde ein "Reactive Ion Etcher" von Oxford Plasma, Gerät: PlasmaLab 80 plus verwendet. Andere im Stand der Technik bekannte Vorrichtungen sind jedoch grundsätzlich ebenso geeignet. Das Ätzen beinhaltete zwei Behandlungsschritte mit verschiedenen Ätzmitteln, die mehrmals hintereinander durchgeführt wurden.

### 1. Schritt:

Als Ätzmittel (Prozessgas) wurde eine Mischung von Ar/SF₆/O₂ im Verhältnis 10:40:8 (sccm) verwendet.
Druck: 50m Torr
RF-Leistung: 120 W
Zeit: 60 s

### 2. Schritt:

Ätzmittel: Ar/CHF₃:10:40
Druck:50 mTorr
RF-Leistung:120 W
ICP-Leistung: 20 W
Zeit: 20 s

Diese 2 Schritte wurden abwechselnd 8 mal wiederholt.

Danach erfolgt eine zehnminütige Ultraschallbehandlung in Wasser und/oder einem Alkohol (z.B. Ethanol). Im konkreten Fall wurde ein Bandelin Sonorex, Typ RK 57, als Ultraschallgerät verwendet. Andere im Stand der Technik bekannte Ultraschallgeräte sind jedoch grundsätzlich ebenso geeignet. Zur Beschallung wurde die Probe aufrecht stehend mit Hilfe eines Teflonhalters in ein Becherglas eingebracht. Danach wurde das Becherglas soweit mit Ethanol und/oder Wasser aufgefüllt, bis die Substratprobe vollständig bedeckt war. Anschließend wurde das Becherglas in das Ultraschallgerät gestellt und typischerweise bei mittlerer Energiestufe für 10 Minuten beschallt. Erforderlichenfalls kann die Dauer oder Energie der Ultrabeschallung variiert werden. Nachbehandlungen sind grundsätzlich nicht erforderlich, aber ein gründliches Abspülen zur Entfernung evtl. noch vorhandener Bruchstücke kann vorteilhaft sein.

### BEISPIEL 2

### Charakterisierung von Nanostrukturen

Von den erfindungsgemäß erhaltenen Nanostrukturen und von Nanostrukturen des Standes der Technik wurden mit dem Rasterelektronenmikroskop Aufnahmen unter verschiedenen Neigungswinkeln gemacht.

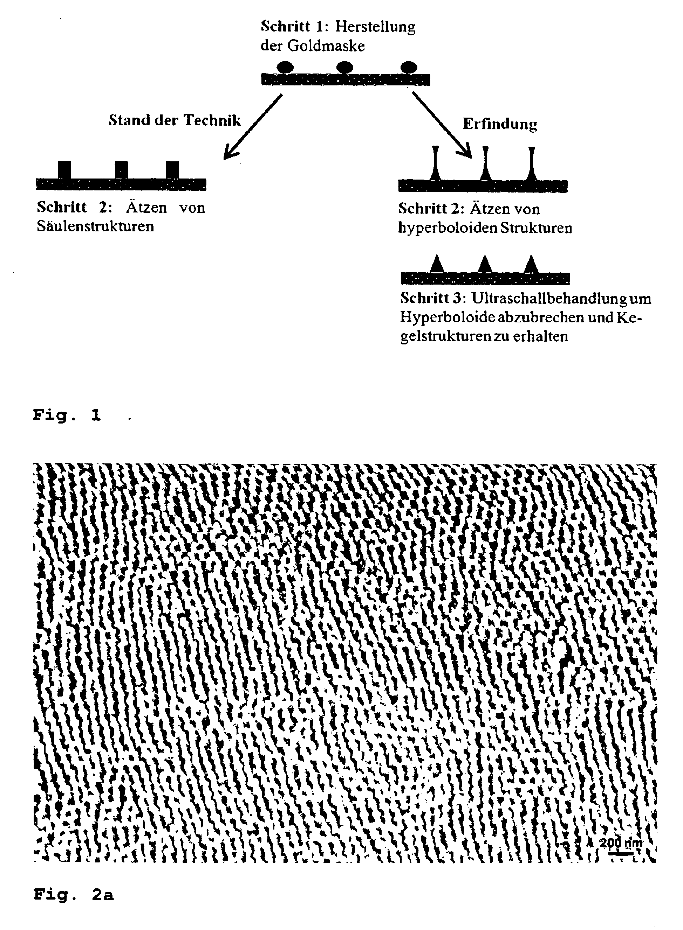

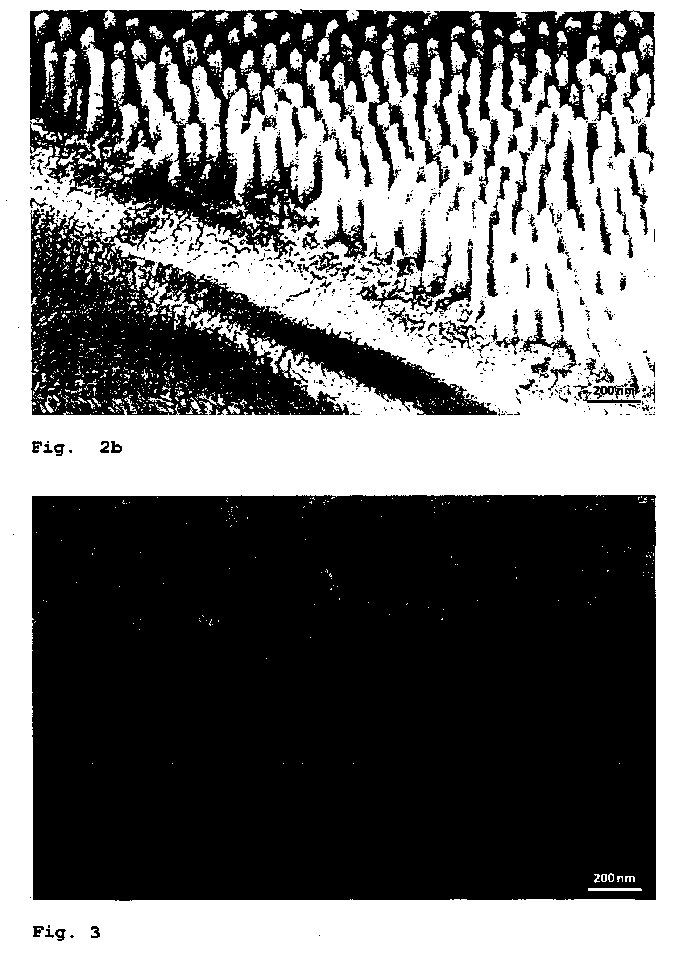

Fig. 2a zeigt eine rasterelektronenmikroskopische Aufnahme in einem Neigungswinkel von 20° von geätzten säulenförmigen Nanostrukturen, die mit einem ähnlichen Verfahren wie in DE 2007 014 538 beschrieben hergestellt wurden. Das Verfahren wurde etwas abgewandelt (andere Ätzchemie, mehrere Ätzschritte), um tiefere Strukturen erzeugen zu können. Mit den speziell genannten Ätzbedingungen des alten Verfahrens sind keine Strukturen tiefer als 120 nm herstellbar. Die Säulen haben eine Höhe von etwa 250 nm und einen Durchmesser von etwa 50 nm. Ihr mittlerer Abstand beträgt etwa 80 nm. Fig. 2b zeigt eine vergrößerte seitliche Ansicht derselben Strukturen unter einem Winkel von 45°. Zuvor wurde in die Oberfläche ein Kratzer mittels eines Diamantschreibers gemacht, um einen Blick auf die Form zu ermöglichen.

Fig. 3 zeigt eine rasterelektronenmikroskopische Aufnahme von geätzten Hyperboloid-Strukturen, die mit dem erfindungsgemäßen Verfahren hergestellt wurden, bei einem Neigungswinkel von 45°. Höhe der Strukturen etwa 500 nm. Die Verengung (mechanischer Schwachpunkt) in etwa halber Höhe ist deutlich zu sehen.

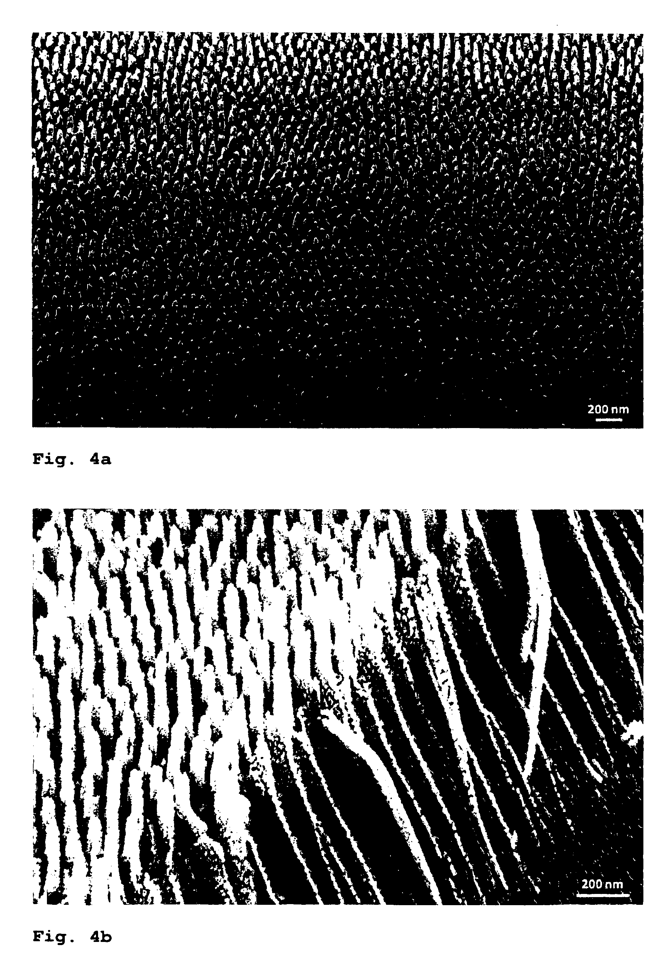

Fig. 4 zeigt rasterelektronenmikroskopische Aufnahmen von geätzten konusförmigen Nanostrukturen, die mit dem erfindungsgemäßen Verfahren hergestellt wurden, bei einem Neigungswinkel von 45° und zwei verschiedenen Vergrößerungen. Die Strukturen haben eine Höhe von etwa 250 nm und einen Durchmesser an der Spitze von etwa 35 nm und an der Basis etwa 60 nm. Dies ergibt einen Seitenwandwinkel von etwa 5,5°. Ihr mittlerer Abstand beträgt etwa 80 nm.

Zur Beurteilung der reflexionsmindernden Wirkung der Strukturen wurden Transmissionsmessungen durchgeführt.

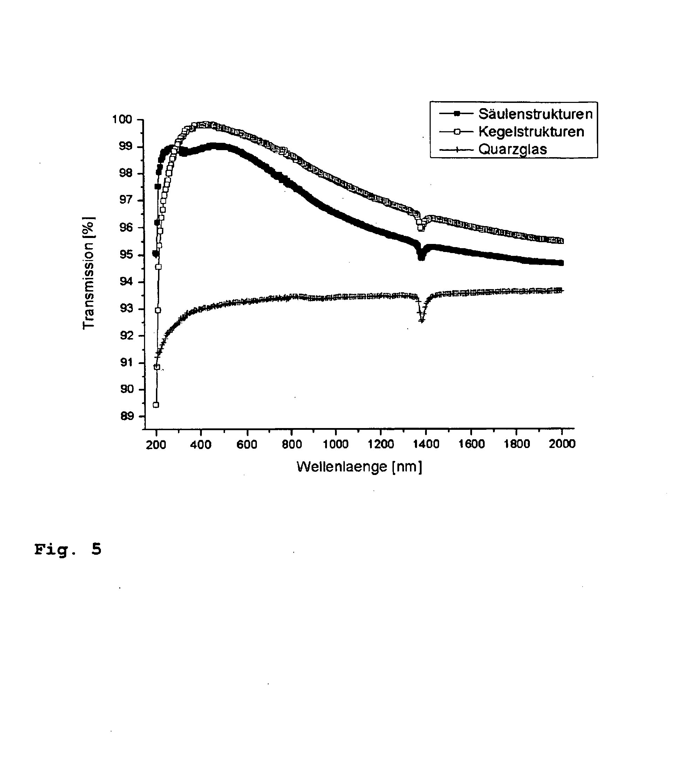

Fig. 5 zeigt Transmissionsmessungen, welche die bessere Performance von Quarzglas-Oberflächen mit den erfindungsgemäß erhaltenen konusförmigen Strukturen im Vergleich zu massiven säulenförmigen Strukturen und unbeschichteten Oberflächen belegen. Die Kurve mit den kegelförmigen Strukturen ist- wesentlich breitbandiger, zeigt keine "Interferenzphänomene" im Verlauf und eine höhere Absoluttransmission. Die Messung aller Proben erfolgte im selben Spektrometer mit denselben Lichtquellen.

## Patentansprüche

1. Verfahren zur Erzeugung von konusförmigen Nanostrukturen auf Substratoberflächen, umfassend
a) Bereitstellen einer mit Nanopartikeln bedeckten Substratoberfläche;
b) Ätzen der mit Nanopartikeln bedeckten Substratoberfläche in einer Tiefe von mindestens 100 nm, wobei die Nanopartikel als Ätzmaske wirken und die Ätzparameter so eingestellt werden, dass unterhalb der Nanopartikel Hyberboloid-Strukturen entstehen,
c) Brechen der Hyberboloid-Strukturen im Bereich des geringsten Durchmessers durch Ausübung mechanischer Kräfte, wobei die auf der Substratoberfläche verbleibenden Strukturen eine konusförmige Gestalt aufweisen, welche im Wesentlichen einer Hälfte eines einschaligen Hyberboloids entspricht.

2. Verfahren nach Anspruch 1, **dadurch gekennzeichnet, dass** die Ausübung mechanischer Kräfte in Schritt c) durch eine Ultraschallbehandlung, Einwirkung von Vibrationen, pneumatischen Kräften oder durch Reibung geschieht.

3. Verfahren nach Anspruch 1 oder 2, **dadurch gekennzeichnet, dass** das Ätzen eine Behandlung mit einem Ätzmittel, das aus der Gruppe aus Chlor, gasförmigen Chlorverbindungen, Fluorkohlenwasserstoffen, Fluorocarbonen, Sauerstoff, Argon, SF₆ und Mischungen davon ausgewählt ist, umfasst.

4. Verfahren nach einem der Ansprüche 1-3, **dadurch gekennzeichnet, dass** das Ätzen mehrere Behandlungen mit demselben Ätzmittel und/oder mit verschiedenen Ätzmitteln umfasst.

5. Verfahren nach Anspruch 4, **dadurch gekennzeichnet, dass** das Ätzen mindestens eine Behandlung mit einer Mischung von Ar/SF₆/O₂ als Ätzmittel und mindestens eine Behandlung mit einer Mischung von Ar/CHF₃ als Ätzmittel umfasst.

6. Verfahren nach einem der Ansprüche 1-5, **dadurch gekennzeichnet, dass** die Ätzbehandlung für einen Zeitraum im Bereich von 1 min bis 30 min durchgeführt wird.

7. Verfahren nach einem der Ansprüche 1-6, **dadurch gekennzeichnet, dass** die Nanopartikel eine vorgegebene zweidimensionale geometrische Anordnung aufweisen.

8. Verfahren nach einem der Ansprüche 1-6, **dadurch gekennzeichnet, dass** das Material der Substratoberfläche aus der Gruppe aus Quarzglas, SiO₂, Si, Al₂O₃, CaF₂, GaAs ausgewählt ist.

9. Verfahren nach einem der Ansprüche 1-8, **dadurch gekennzeichnet, dass** das Material der Nanopartikel Metalle oder Metalloxide umfasst oder daraus besteht.

10. Verfahren nach Anspruch 9, **dadurch gekennzeichnet, dass** das Metall oder die Metallkomponente der Nanopartikel aus der Gruppe aus Au, Pt, Pd, Ag, In, Fe, Zr, Al, Co, Ni, Ga, Sn, Zn, Ti, Si und Ge, deren Mischungen und Kompositen ausgewählt ist.

11. Verfahren nach Anspruch 10, **dadurch gekennzeichnet, dass** es sich bei den Nanopartikeln um Gold-Nanopartikel handelt.

12. Verfahren nach einem der Ansprüche 1-11, **dadurch gekennzeichnet, dass** die Nanopartikel durch mizellare Nanolithographie auf der Substratoberfläche aufgebracht wurden.

13. Verfahren nach einem der Ansprüche 1-12, **dadurch gekennzeichnet, dass** die Substratoberfläche die Oberfläche eines optischen Elements ist und die erzeugten konusförmigen Nanostrukturen eine reflexionsmindernde Oberflächenstruktur auf dem optischen Element bilden.

## Claims

1. A method for creating conical nanostructures on substrate surfaces, comprising
a) providing a substrate surface covered with nanoparticles;
b) etching the substrate surface covered with nanoparticles to a depth of at least 100 nm, wherein the nanoparticles act as etching mask and the etching parameters are set in such a manner that hyperboloid structures arise below the nanoparticles,
c) breaking the hyperboloid structures in the region of the smallest diameter by exerting mechanical forces, wherein the structures remaining on the substrate surface have a conical shape which essentially corresponds to half of a hyperboloid of one sheet.

2. The method according to Claim 1, **characterized in that** the exertion of mechanical forces in step c) takes place by means of an ultrasound treatment, action of vibrations, pneumatic forces or by means of friction.

3. The method according to Claim 1 or 2, **characterized in that** the etching comprises a treatment with an etchant which is selected from the group of chlorine, gaseous chlorine compounds, fluorinated hydrocarbons, fluorocarbons, oxygen, argon, SF₆ and mixtures thereof.

4. The method according to any one of Claims 1-3, **characterized in that** the etching comprises a plurality of treatments with the same etchant and/or with various etchants.

5. The method according to Claim 4, **characterized in that** the etching comprises at least one treatment with a mixture of Ar/SF₆/O₂ as etchant and at least one treatment with a mixture of Ar/CHF₃ as etchant.

6. The method according to any one of Claims 1-5, **characterized in that** the etching treatment is carried out for a period in the range of 1 min to 30 min.

7. The method according to any one of Claims 1-6, **characterized in that** the nanoparticles have a predetermined two-dimensional geometric arrangement.

8. The method according to any one of Claims 1-6, **characterized in that** the material of the substrate surface is selected from the group made up of quartz glass, SiO₂, Si, Al₂O₃, CaF₂, GaAs.

9. The method according to any one of Claims 1-8, **characterized in that** the material of the nanoparticles comprises metals or metal oxides or consists of the same.

10. The method according to Claim 9, **characterized in that** the metal or the metal component of the nanoparticles is selected from the group made up of Au, Pt, Pd, Ag, In, Fe, Zr, Al, Co, Ni, Ga, Sn, Zn, Ti, Si and Ge, mixtures and composites thereof.

11. The method according to Claim 10, **characterised in that** the nanoparticles are gold nanoparticles.

12. The method according to any one of Claims 1-11, **characterized in that** the nanoparticles were applied to the substrate surface by means of micellar nanolithography.

13. The method according to any one of Claims 1-12, **characterized in that** the substrate surface is the surface of an optical element and the conical nanostructures created form an anti-reflection surface structure on the optical element.

## Revendications

1. Procédé de production de nanostructures de forme conique sur des surfaces de substrat, comprenant
a) la mise à disposition d'une surface de substrat revêtue de nanoparticules ;
b) la gravure de la surface de substrat revêtue par des nanoparticules en une profondeur d'au moins 100 nm, dans lequel les nanoparticules font office de masque de gravure et les paramètres de gravure sont ajustés de telle sorte que sous les nanoparticules se forment des structures hyperboloïdes,
c) la rupture des structures hyperboloïdes dans la région du diamètre le plus faible en exerçant des forces mécaniques, dans lequel les structures restant sur la surface de substrat présentent une configuration conique qui correspond sensiblement à une moitié d'un hyperboloïde monocouche.

2. Procédé selon la revendication 1, **caractérisé en ce que** l'exercice de forces mécaniques de l'étape c) s'effectue par un traitement à ultrasons, sous l'effet de vibrations, de forces pneumatiques ou par frottement.

3. Procédé selon la revendication 1 ou 2, **caractérisé en ce que** la gravure comprend un traitement avec un décapant qui est choisi dans le groupe comprenant le chlore, des composés de chlore sous forme gazeuse, des hydrofluorocarbones, des fluorocarbones, de l'oxygène, de l'argon, du SF₆ et des mélanges de ceux-ci.

4. Procédé selon l'une des revendications 1 à 3, **caractérisé en ce que** la gravure comprend plusieurs traitements avec le même décapent et/ou avec différents décapants.

5. Procédé selon la revendication 4, **caractérisé en ce que** la gravure comprend au moins un traitement avec un mélange d'AR/SF₆/O₂ comme décapant et au moins un traitement avec un mélange d'Ar/CHF₃ comme décapant.

6. Procédé selon l'une des revendications 1 à 5, **caractérisé en ce que** le traitement par gravure est réalisé pendant une durée dans la plage de 1 min à 30 min.

7. Procédé selon l'une des revendications 1 à 6, **caractérisé en ce que** les nanoparticules présentent une disposition géométrique bidimensionnelle définie.

8. Procédé selon l'une des revendications 1 à 6, **caractérisé en ce que** le matériau de la surface de substrat est choisi dans le groupe comprenant le verre de quartz, le SiO₂, le Si, l'Al₂O₃, le CaF₂, le GaAs.

9. Procédé selon l'une des revendications 1 à 8, **caractérisé en ce que** le matériau des nanoparticules comprend des métaux ou des oxydes métalliques ou est constitué de ceux-ci.

10. Procédé selon la revendication 9, **caractérisé en ce que** le métal ou les composants métalliques des nanoparticules est/sont choisis dans le groupe comprenant les Au, Pt, Pd, Ag, In, Fe, Zr, Al, Co, Ni, Ga, Sn, Zn, Ti, Si et Ge, leurs mélanges et composites.

11. Procédé selon la revendication 10, **caractérisé en ce que** les nanoparticules sont des nanoparticules d'or.

12. Procédé selon l'une des revendications 1 à 11, **caractérisé en ce que** les nanoparticules ont été appliquées par nanolithographie micellaire sur la surface de substrat.

13. Procédé selon l'une des revendications 1 à 12, **caractérisé en ce que** la surface de substrat est la surface d'un élément optique et les nanostructures en forme de cônes produites forment une structure de surface réduisant les reflets sur l'élément optique.
